# EUROPÄISCHE PATENTANMELDUNG

(11) **EP 0 656 651 A2**
(43) Veröffentlichungstag der Anmeldung: **07.06.1995**
(21) Anmeldenummer: 94118236.2
(22) Anmeldetag: 18.11.1994
(51) Int. Cl.: H01L 21/76

(54) **Verfahren zur Herstellung einer integrierten Schaltungsanordnung**

(30) Priorität: 02.12.1993 DE 4341171
(71) Anmelder: SIEMENS AKTIENGESELLSCHAFT, D-80333 München (DE)
(72) Erfinder: Schwalke, Udo, Jr., D-84431 Heldenstein (DE); Bieringer, Fritz, Dipl.-Ing., D-80809 München (DE)

(57) **Zusammenfassung**

In einer Substratscheibe (1) wird in einem zweistufigen Grabenprozeß eine Grabenstruktur (14) hergestellt, wobei in einem ersten Ätzschritt eine Grabenmaske (10) erzeugt wird und in einem zweiten Ätzschritt die Grabenstruktur (14) in der Substratscheibe (1) realisiert wird. Bei dem Grabenprozeß wird in der Substratscheibe (1) eine Lithographiehilfsstruktur erzeugt. Bei der Herstellung einer Grabenmaske (14) wird im Bereich (L) der Lithographiehilfsstruktur eine Schutzstruktur (2) gebildet, die die Substratscheibe (1) im Bereich (L) der Lithographiehilfsstruktur vor einem Ätzangriff im zweiten Ätzschritt schützt.

## Beschreibung

Zur Herstellung von integrierten Schaltungen sind komplexe Prozeßfolgen mit mehreren Lithographieschritten erforderlich. In den Prozeßschritten werden in jeder Maskenebene Lithographiehilfsstrukturen in dem Substrat, in dem auch die integrierte Schaltung hergestellt wird, erzeugt. Diese Lithographiehilfsstrukturen werden zur Justierung der nächsten Maskenebene sowie zur Bewertung der Prozeßschritte verwendet. Die Lithographiehilfsstrukturen unterliegen dabei denselben Prozeßeinflüssen wie die Strukturen der herzustellenden integrierten Schaltung (siehe zum Beispiel S. Wolf et al, Silicon processing for the VLSI-Era, Lattice Press, 1987, Seite 473 bis 476.

In Schaltungsanordnungen mit erhöhter Packungsdichte werden zunehmend Grabenstrukturen verwendet. Derartige Grabenstrukturen werden unter anderem mit isolierendem Material gefüllt und als Isolationsgräben zur Isolation zwischen benachbarten Schaltelementen, zum Beispiel zwischen Bipolartransistoren oder zwischen Leistungsbauelementen und Logikbauelementen eingesetzt. Die Grabenstruktur wird in das Substrat hineingeätzt. Bei der Herstellung der Grabenstruktur wird die Lithographiehilfsstruktur ebenfalls dem Grabenätzprozeß unterzogen.

Wenn die Lithographiehilfsstrukturen weiter als die Grabenstrukturen sind, was in heutigen Technologien vielfach der Fall ist, kommt es beim Auffüllen tiefer Gräben nicht zu einem vollständigen Auffüllen der Lithographiehilfsstrukturen. Die Oberfläche der Struktur weist dann im Bereich der Lithographiehilfsstrukturen Stufen auf, die dazu führen, daß eine sichere, fertigungstaugliche Prozeßführung nicht mehr möglich ist. Besonders gravierend ist dieses Problem bei der Smart Power Technologie auf SOI-Material. Dabei werden in einer einkristallinen Siliziumschicht, die auf einer isolierenden Schicht angeordnet ist, Logikbauelemente und Leistungsbauelemente realisiert, die jeweils von einem isolierenden Graben, der bis auf die Oberfläche der isolierenden Schicht reicht, umgeben sind (siehe zum Beispiel A. Nagakawa et al, ISPS 1990, S. 97 bis 101). Bei dieser Anwendung treten Grabenstrukturen mit Weiten von 1 bis 3 µm und Tiefen von 20 bis 30 µm auf. Lithographiehilfsstrukturen, deren Geometrie in der Regel vom Gerätehersteller vorgegeben ist, weisen dagegen Weiten im Bereich 3 bis 30 µm auf.

Der Erfindung liegt das Problem zugrunde, ein Verfahren zur Herstellung einer integrierten Schaltungsanordnung anzugeben bei dem Grabenstrukturen und Lithographiehilfsstrukturen so hergestellt werden, daß eine sichere und fertigungstaugliche Prozeßführung möglich ist. Dazu sollen insbesondere hohe Stufen in der Oberfläche vermieden werden.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird eine Grabenstruktur in einem zweistufigen Grabenprozeß, der mindestens zwei Ätzschritte umfaßt, hergestellt. Dabei wird zunächst eine Grabenmaske an der Oberfläche einer Substratscheibe durch Abscheidung einer Schicht und Strukturierung der Schicht hergestellt. Die Strukturierung der Schicht stellt den ersten Ätzschritt des Grabenprozesses dar. Anschließend wird in einem zweiten Ätzschritt die Grabenstruktur in der Substratscheibe realisiert. Beim zweiten Ätzschritt wird das Material der Substratscheibe angegriffen. Bei dem Grabenprozeß wird gleichzeitig außerhalb der integrierten Schaltungsanordnung eine Lithographiehilfsstruktur in der Substratscheibe hergestellt. Lithographiehilfsstrukturen sind zum Beispiel Justiermarken, Auflösungsmuster zur Fokus- und Maßbestimmung sowie Nonien und andere Überlagerungsstrukturen zur Lagefehlerbestimmung. Bei der Herstellung der Grabenmaske wird im Bereich der Lithographiehilfsstruktur eine Schutzstruktur gebildet, die die Substratscheibe im Bereich der Lithographiehilfsstruktur vor einem Ätzangriff im zweiten Ätzschritt schützt. Dazu wird zum Beispiel an der Oberfläche der Substratscheibe im Bereich der Lithographiehilfsstruktur lokal eine dem zweiten Ätzschritt widerstehende Schicht aufgebracht.

Die Schutzstruktur im Bereich der Lithographiehilfsstruktur kann bei einer Substratscheibe, die mindestens im Bereich einer Hauptfläche Silizium umfaßt, durch ganzflächiges Aufbringen einer Schichtenfolge auf die Hauptfläche erfolgen. Die Schichtenfolge umfaßt mindestens eine auf der Hauptfläche angeordnete SiO₂-Schicht und eine darauf angeordnete Siliziumschicht, die vorzugsweise aus Polysilizium besteht. Die Siliziumschicht wird nun lokal mindestens im Bereich der Grabenstruktur oxidiert, während die Siliziumschicht im Bereich der Lithographiehilfsstruktur nicht oxidiert wird und hier als Siliziumschicht bestehen bleibt.

Der erste Ätzschritt zur Herstellung der Grabenmaske wird nun selektiv zu Silizium durchgeführt, so daß die Ätzung im Bereich der Grabenstruktur auf der Hauptfläche der Substratscheibe, im Bereich der Lithographiehilfsstruktur jedoch auf der Siliziumschicht stoppt. Im Bereich der Grabenstruktur wird im ersten Ätzschritt sowohl das durch lokale Oxidation entstandene Oxid als auch die SiO₂-Schicht durchgeätzt. Im Bereich der Lithographiehilfsstruktur ist die SiO₂-Schicht durch die Siliziumschicht geschützt.

Im zweiten Ätzschritt wird die Grabenstruktur durch Ätzen in das Silizium der Substratscheibe hergestellt. Dazu wird eine zu SiO₂ selektive Ätzung verwendet, die im Bereich der Lithographiehilfsstruktur nur die Siliziumschicht angreift, während sie auf der darunter angeordneten SiO₂-Schicht stoppt. Die SiO₂-Schicht wirkt hier als Schutzstruktur.
Diese Ausführungsform des erfindungsgemäßen Verfahrens ist vorteilhaft einsetzbar in Prozeßfolgen, in denen vor der Grabenätzung Feldoxidbereiche hergestellt werden. Diese Feldoxidbereiche werden insbesondere in einem modifizierten LOCOS-Verfahren gebildet, das zum Beispiel aus R. Burmester et al, ESSCERC 1988, bekannt ist. Dabei wird die lokale Oxidation unter Verwendung einer Schichtenfolge aus SiO₂, Polysilizium und Si₃N₄ durchgeführt. Die beschriebene Ausführungsform der Erfindung kann in einen solchen Prozeß eingefügt werden, ohne daß eine zusätzliche Phototechnik erforderlich wäre. Die Dicke der SiO₂-Schicht, die an der Oberfläche der Substratscheibe angeordnet ist, muß auf die Selektivität der im zweiten Ätzschritt eingesetzten Ätzung sowie die Tiefe der Grabenstruktur eingestellt werden.

Als Substratscheibe ist in dem erfindungsgemäßen Verfahren sowohl ein SOI-Substrat als auch ein einkristallines Siliziumsubstrat geeignet. Bei einem einkristallinen Siliziumsubstrat wird die Tiefe der Grabenstruktur über die Ätzzeit eingestellt.

Im folgenden wird die Erfindung anhand eines Ausführungsbeispiels und der Figuren näher erläutert.
- Figur 1: zeigt eine Substratscheibe mit einer SiO₂-Schicht, einer Polysiliziumschicht und einer Si₃N₄-Schicht.
- Figur 2: zeigt die Substratscheibe nach der Strukturierung der Si₃N₄-Schicht für eine lokale Oxidation.
- Figur 3: zeigt die Substratscheibe vor der Strukturierung von Schichten zur Herstellung einer Grabenmaske.
- Figur 4: zeigt die Substratscheibe nach dem ersten Ätzschritt.
- Figur 5: zeigt die Substratscheibe nach dem zweiten Ätzschritt.
- Figur 6: zeigt die Substratscheibe nach der Bildung von Spacern entlang den Wänden der Grabenstruktur.
- Figur 7: zeigt die Substratscheibe nach dem Auffüllen der Grabenstruktur.

Das erfindungsgemäße Verfahren wird am Beispiel eines 500 Volt Smart-Power-Prozesses beschrieben. Ausgangsmaterial ist eine Substratscheibe 1 aus SOI-Material. Die Substratscheibe 1 umfaßt ein einkristallines Siliziumsubstrat 11, eine darauf angeordnete isolierende Schicht 12 aus SiO₂, die eine Dicke von zum Beispiel 2 µm aufweist und eine darauf angeordnete schwach n-dotierte monokristalline Siliziumschicht 13, die zum Beispiel 20 µm dick ist. Die Substratscheibe 1 ist vorzugsweise nach dem Direct-wafer-bonding (DWB)-Verfahren hergestellt, das zum Beispiel aus A. Nagakawa et al, ISPS 1990, S. 97 bis 101, bekannt ist.

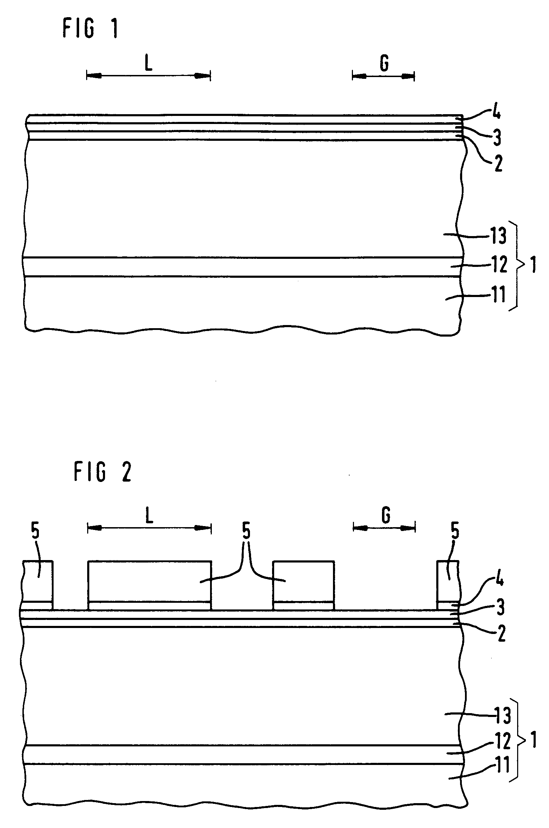

Auf der Oberfläche der monokristallinen Siliziumschicht 13 wird eine SiO₂-Schicht 2 zum Beispiel durch eine thermische Oxidation der Oberfläche erzeugt (siehe Figur 1). Die SiO₂-Schicht 2 wird in einer Dicke im Bereich 50 bis 300 nm erzeugt.

Auf die SiO₂-Schicht 2 wird eine polykristalline Siliziumschicht 3 in einer Dicke von zum Beispiel 50 bis 250 nm und darauf eine Si₃N₄-Schicht 4 in einer Dicke von zum Beispiel 50 bis 250 nm abgeschieden.

In Figur 1 ist als Doppelpfeil L ein Bereich für eine Lithographiehilfsstruktur und als Doppelpfeil G ein Bereich für eine Grabenstruktur bezeichnet. Die Lithographiehilfsstruktur wird durch Kontrastumkehr als inverse Überlagerungsstruktur ausgeführt.

Es wird ganzflächig eine Photolackschicht 5 aufgebracht und so belichtet und entwickelt, daß im Bereich G für die Grabenstruktur die Oberfläche der Si₃N₄-Schicht 4 freigelegt wird, während im Bereich L für die Lithographiehilfsstruktur der Photolack auf der Si₃N₄-Schicht 4 verbleibt. In einem anisotropen Trockenätzverfahren wird die Si₃N₄-Schicht 4 strukturiert (siehe Figur 2). Das anisotrope Trockenätzverfahren ist vorzugsweise selektiv zu Polysilizium, so daß der Ätzprozeß auf der Oberfläche der Polysiliziumschicht 3 stoppt. Als Ätzprozeß ist zum Beispiel ein Plasmaätzverfahren mit CHF₃/O₂Chemie geeignet.

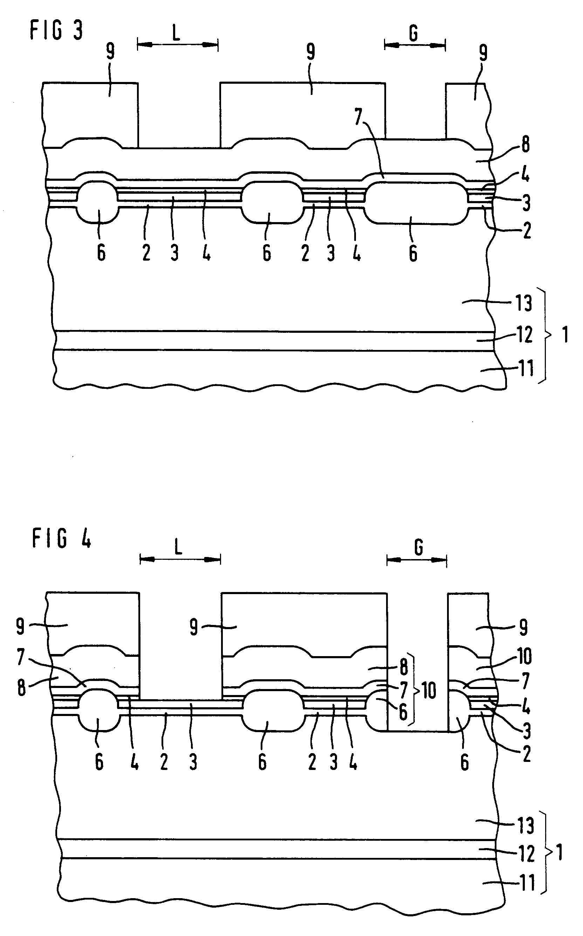

Durch lokale Oxidation unter Verwendung der Si₃N₄-Schicht 4 als Oxidationsmaske werden in den von der strukturierten Si₃N₄-Schicht 4 nicht bedeckten Bereichen Feldoxidbereiche 6 erzeugt (siehe Figur 3). Bei der lokalen Oxidation oxidieren die freiliegenden Teile der Polysiliziumschicht 3 vollständig auf. Da der Bereich L für die Lithographiehilfsstruktur von der Si₃N₄-Schicht 4 bedeckt ist, bleibt in diesem Bereich die Polysiliziumschicht 3 erhalten. Im Bereich G für die Grabenstruktur dagegen liegt die Oberfläche der Polysiliziumschicht 3 frei, so daß das Polysilizium hier vollständig aufoxidiert wird.

Nach Entfernung der Photolackschicht 5 wird ganzflächig eine weitere Si₃N₄-Schicht 7 in einer Dicke von zum Beispiel 20 bis 200 nm und darauf eine weitere SiO₂-Schicht 8 in einer Dicke von zum Beispiel 200 bis 1.000 nm abgeschieden. Die weitere SiO₂-Schicht 8 wird in einem CVD-Verfahren abgeschieden. Die weitere SiO₂-Schicht 8 muß für eine Grabenmaske geeignet sein. Insbesondere wird sie zum Einstellen der Flanken der Grabenstruktur benötigt. Die weitere Si₃N₄-Schicht 7 dient als Ätzstop für das spätere Entfernen der SiO₂-Schicht 8 in einem naßchemischen Ätzprozeß.

Es wird ganzflächig eine weitere Photolackschicht 9 aufgebracht und so belichtet und entwickelt, daß sowohl der Bereich G für die Grabenstruktur als auch der Bereich L für die Lithographiehilfsstruktur freigelegt werden.

Nachfolgend wird ein erster Ätzschritt zur Herstellung einer Grabenmaske 10 durchgeführt (siehe Figur 4). Dazu wird ein anisotroper Trockenätzprozeß verwendet, der SiO₂ und Si₃N₄ mit nahezu gleichen Ätzraten ätzt, der jedoch Silizium mit einer wesentlich geringeren Ätzrate ätzt. Daher werden im ersten Ätzschritt die weitere SiO₂-Schicht 8 und die weitere Si₃N₄-Schicht 7 strukturiert. Im Bereich L der Lithographiehilfsstruktur stoppt die Ätzung auf der Oberfläche der Polysiliziumschicht 3. Im Bereich G für die Grabenstruktur wird dagegen der Feldoxidbereich 6 ebenfalls durchätzt und die Ätzung stoppt auf der Oberfläche der monokristallinen Siliziumschicht 13 (siehe Figur 4). Die Grabenmaske 10 wird im Bereich G für die Grabenstruktur durch den Feldoxidbereich 6, die weitere Si₃N₄-Schicht 7 sowie die weitere SiO₂-Schicht 8 gebildet. Als Ätzprozeß für den ersten Ätzschritt ist zum Beispiel ein CHF₃/O₂-Plasma geeignet.

Nach dem ersten Ätzschritt wird die weitere Photolackschicht 9 entfernt. Es wird ein zweiter Ätzschritt durchgeführt. Dazu wird ein anisotroper Trockenätzprozeß verwendet, der Silizium hochselektiv zu SiO₂ ätzt. Dazu ist insbesondere ein Plasmaätzprozeß mit HBr/NF₃ + He/O₂ Chemie geeignet. Dieser Prozeß weist eine Selektivität von etwa 100 : 1 für die Ätzung Silizium zu SiO₂ auf.

Im Bereich G für die Grabenstruktur stoppt die Ätzung im zweiten Ätzschritt daher auf der Oberfläche der isolierenden Schicht 12 aus SiO₂, wodurch im Bereich der monokristallinen Siliziumschicht 13 eine Grabenstruktur 14 erzeugt wird. Die Grabenstruktur 14 weist eine Tiefe entsprechend der Dicke der monokristallinen Siliziumschicht 12, das heißt von 20 µm und eine Weite von 2 µm auf. Im Bereich L für die Lithographiehilfsstruktur wird im zweiten Ätzschritt die freiliegende Polysiliziumschicht 3 entfernt. Die Ätzung im zweiten Ätzschritt stoppt dann auf der Oberfläche der SiO₂-Schicht 2, die im Bereich L für die Lithographiehilfsstruktur als Schutzstruktur wirkt. Die Dicke der SiO₂-Schicht 2 muß daher auf die Tiefe der Grabenstruktur 14 und die Selektivität der im zweiten Ätzschritt verwendeten Ätzung eingestellt werden. Insbesondere bei der Herstellung von Grabenstrukturen mit Tiefen größer 20 µm kann dabei die erforderliche Dicke der SiO₂-Schicht 2 größer sein, als es für die lokale Oxidation (LOCOS) zur Bildung der Feldoxidbereiche in einem Standard-CMOS-Prozeß, in dem das erfindungsgemäße Verfahren zur Herstellung der Grabenstruktur eingebettet ist, erforderlich ist.

Falls es im Sinne des Gesamtprozesses nicht tragbar erscheint, die Dicke der SiO₂-Schicht entsprechend größer zu wählen, liegt es im Rahmen der Erfindung, vor der Abscheidung der SiO₂-Schicht 2 im Bereich L für die Lithographiehilfsstruktur lokal eine zusätzliche SiO₂-Struktur (nicht dargestellt) zu erzeugen. Dieses kann durch lokale Oxidation oder durch Abscheidung von SiO₂ erfolgen. Dazu ist eine Maske erforderlich. Es ist besonders vorteilhaft, diese SiO₂-Struktur bei einem vorhergehenden Prozeßschritt des Gesamtprozesses, zum Beispiel einer Implantation, mit der dazu verwendeten Maske durchzuführen, so daß zur Herstellung der SiO₂-Struktur zwar eine weitere, im Gesamtprozeß jedoch keine zusätzliche Maske erforderlich ist.

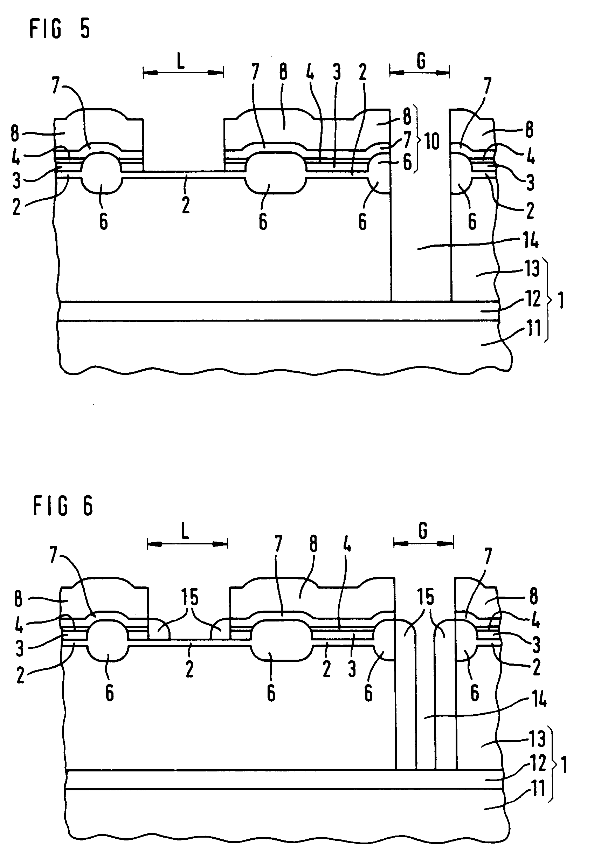

Nachfolgend wird die Grabenstruktur 14 entsprechend der vorgesehenen Anwendung aufgefüllt. Dazu wird zum Beispiel zunächst ganzflächig eine amorphe Siliziumschicht mit im wesentlichen konformer Kantenbedeckung abgeschieden und anisotrop geätzt, wodurch sich Siliziumspacer 15 entlang senkrechten Flanken ausbilden (siehe Figur 6).

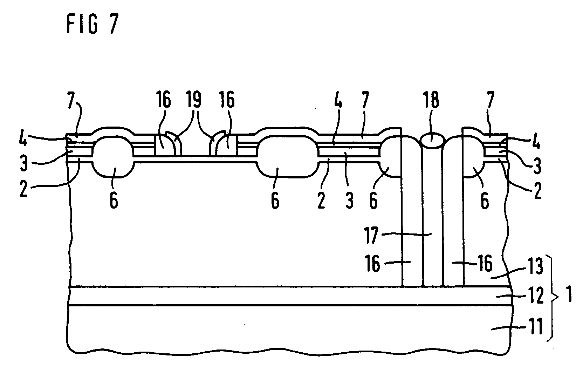

Anschließend wird die weitere SiO₂-Schicht 8 naßchemisch entfernt, wobei die weitere Si₃N₄-Schicht 7 als Ätzstop wirkt (siehe Figur 7). Durch Oxidation der Siliziumspacer 15 werden in der Grabenstruktur 14 sowie im Bereich der Lithographiehilfsstruktur SiO₂-Spacer 16 gebildet. Durch wiederholtes Abscheiden von amorphem Silizium mit im wesentlichen konformer Kantenbedeckung wird die Grabenstruktur 14 mit einer Siliziumfüllung 17 aufgefüllt. Durch Aufoxidation der Siliziumfüllung 17 wird die Grabenstruktur 14 mit einem SiO₂-Abschluß 18 verschlossen. Gleichzeitig werden im Bereich L der Lithographiehilfsstruktur weitere SiO₂-Spacer 19 gebildet (siehe Figur 7).

Nach Entfernen der weiteren Si₃N₄-Schicht 7, der Si₃N₄-Schicht 4, der Polysiliziumschicht 3 sowie der SiO₂-Schicht 2 können die konventionellen Prozeßschritte eines Gesamtprozesses fortgesetzt werden.

Beim Entfernen der SiO₂-Schicht 2 wird sowohl der SiO₂-Abschluß 18 als auch die Feldoxidbereiche 6 gedünnt. Da die Dicke der SiO₂-Schicht 2 durch den Oxidabtrag beim zweiten Ätzschritt vorgegeben ist, muß dies durch eine verlängerte lokale Oxidation zur Herstellung der Feldoxidbereiche 6 bzw. Aufoxidation zur Herstellung des SiO₂-Abschlusses 18 aufgefangen werden. In Anwendungen, in denen dieses zum Beispiel wegen einer Vergrößerung der lateralen Ausdehnung der Feldoxidbereiche 6 durch eine vergrößerte Vogelschnabellänge, nicht möglich ist, kann auch hier vor der Abscheidung der SiO₂-Schicht 2 im Bereich L der Lithographiehilfsstruktur eine SiO₂-Struktur lokal erzeugt werden.

Im Bereich L der Lithographiehilfsstruktur bleiben nach dem Entfernen der Schichtenfolge aufgrund der SiO₂-Spacer 16, 19 Erhebungen stehen, die gemeinsam mit den benachbarten Feldoxidbereichen zur Justierung der nächsten Maskenebene sowie zur Bewertung der Prozeßschritte verwendet werden. Diese Erhebungen bewirken Unebenheiten in der Oberfläche im Bereich einige 100 nm, wie sie auch durch Gateelektroden oder andere Erhebungen der Schaltstrukturen bewirkt werden. Unebenheiten dieser Größenordnung sind im Sinne einer sicheren und fertigungstauglichen Prozeßführung tragbar.

## Patentansprüche

1. Verfahren zur Herstellung einer integrierten Schaltungsanordnung,
- bei dem in einer Substratscheibe (1) unter Verwendung einer Grabenmaske (10) mindestens eine Grabenstruktur (14) in einem mindestens zwei Ätzschritte umfassenden Grabenprozeß hergestellt wird, wobei in einem ersten Ätzschritt die Grabenmaske (10) durch Strukturierung mindestens einer Schicht (8) hergestellt wird und in einem zweiten Ätzschritt die Grabenstruktur (14) in der Substratscheibe (1) realisiert wird,
- bei dem bei dem Grabenprozeß in der Substratscheibe (1) außerhalb der Schaltungsanordnung eine Lithographiehilfsstruktur (L) hergestellt wird,
- bei dem bei der Herstellung der Grabenmaske (10) im Bereich (L) der Lithographiehilfsstruktur eine Schutzstruktur (2) gebildet wird, die die Substratscheibe (1) im Bereich (L) der Lithographiehilfsstruktur vor einem Ätzangriff im zweiten Ätzschritt schützt.

2. Verfahren nach Anspruch 1,
- bei dem vor der Herstellung der Grabenmaske (10) im Bereich (L) der Lithographiehilfsstruktur eine SiO₂-Struktur erzeugt wird,
- bei dem der zweite Ätzschritt selektiv zu SiO₂ erfolgt.

3. Verfahren nach Anspruch 1 oder 2,
- bei dem die Substratscheibe (1) mindestens im Bereich einer Hauptfläche Silizium (13) umfaßt,
- bei dem zur Herstellung der Grabenmaske (10) und der Schutzstruktur (2) auf die Substratscheibe (1) ganzflächig eine Schichtenfolge aufgebracht wird, die mindestens eine auf der Hauptfläche angeordnete SiO₂-Schicht (2) und eine darauf angeordnete Siliziumschicht (3) umfaßt,
- bei dem die Siliziumschicht (3) lokal mindestens im Bereich (G) der Grabenstruktur oxidiert wird, während die Siliziumschicht (3) im Bereich (L) der Lithographiehilfsstruktur nicht oxidiert wird,
- bei dem der erste Ätzschritt zur Herstellung der Grabenmaske (10) selektiv zu Silizium erfolgt, so daß die Ätzung im Bereich (G) der Grabenstruktur auf der Hauptfläche der Substratscheibe (1) und im Bereich (L) der Lithographiehilfsstruktur auf der Siliziumschicht (3) stoppt.

4. Verfahren nach Anspruch 3,
- bei dem die Schichtenfolge ferner eine auf der Siliziumschicht (3) angeordnete Si₃N₄-Schicht (4) und eine Photolackschicht (5) umfaßt,
- bei dem die Photolackschicht (5) so belichtet und entwickelt wird, daß die Si₃N₄-Schicht (4) im Bereich G der Grabenstruktur freigelegt wird und im Bereich L der Lithographiehilfsstruktur die Si₃N₄-Schicht (4) mit Photolack bedeckt bleibt,
- bei dem die Si₃N₄-Schicht (4) in einem anisotropen Ätzprozeß strukturiert wird,
- bei dem durch lokale Oxidation Feldoxidbereiche (6) gebildet werden,
- bei dem die Photolackschicht (5) entfernt wird,
- bei dem ganzflächig eine weitere SiO₂-Schicht (8) abgeschieden wird,
- bei dem eine weitere Photolackschicht (9) aufgebracht und so belichtet und entwickelt wird, daß die weitere SiO₂-Schicht (8) im Bereich (G) der Grabenstruktur und im Bereich (L) der Lithographiehilfsstruktur freigelegt wird,
- bei dem im ersten Ätzschritt ein SiO₂ selektiv zu Silizium angreifender, anisotroper Trockenätzprozeß eingesetzt und durchgeführt wird, bis im Bereich (G) der Grabenstruktur (14) die Hauptfläche der Substratscheibe (1) und im Bereich (L) der Lithographiehilfsstruktur die Oberfläche der Siliziumschicht (3) freigelegt sind,
- bei dem die weitere Photolackschicht (9) entfernt wird,
- bei dem zur Fertigstellung der Grabenstruktur (14) im zweiten Ätzschritt ein Silizium selektiv zu SiO₂ angreifender, anisotroper Trockenätzprozeß eingesetzt und durchgeführt wird.

5. Verfahren nach Anspruch 4,
- bei dem vor dem Abscheiden einer weiteren SiO₂-Schicht (8) eine weitere Si₃N₄-Schicht (7) abgeschieden wird,
- bei dem im ersten Ätzschritt ein SiO₂ und Si₃N₄ selektiv zu Silizium angreifender anisotroper Ätzprozeß eingesetzt wird.

6. Verfahren nach Anspruch 5,
bei dem im ersten Ätzschritt eine Plasmaätzung mittels CHF₃/O₂ Chemie und im zweiten Ätzschritt eine Plasmaätzung mittels HBr/NF₃ + He/O₂ Chemie eingesetzt wird.

7. Verfahren nach einem der Ansprüche 1 bis 6,
bei dem die Grabenstruktur durch im wesentlichen konformes Abscheiden und anisotropes Ätzen der Schicht gefüllt wird.

8. Verfahren nach einem der Ansprüche 1 bis 7,
- bei dem als Substratscheibe (1) ein SOI-Substrat verwendet wird mit einer einkristallinen Siliziumschicht (13), die auf einer isolierenden Schicht (12) angeordnet ist,
- bei dem die Grabenstruktur (14) in der monokristallinen Siliziumschicht (13) erzeugt wird,
- bei dem im zweiten Ätzschritt innerhalb der Grabenstruktur (14) die Oberfläche der isolierenden Schicht (12) freigelegt wird.
